# EUROPEAN PATENT APPLICATION

(11) **EP 1 640 424 A1**
(43) Date of publication of application: **29.03.2006**
(21) Application number: 05255393.0
(22) Date of filing: 02.09.2005
(51) Int. Cl.: C09G 1/02, H01L 21/321

(54) **Polishing composition and process for producing wiring structure using it**

(30) Priority: 17.09.2004 JP 2004272059
(71) Applicant: FUJIMI INCORPORATED, Aichi (JP)
(72) Inventor: Hirano, Tatsuhiko, c/o Fujimi Incorporated, Kiyosu-shi Aichi (JP); Oh, Junhui, c/o Fujimi Incorporated, Kiyosu-shi Aichi (JP); Sakao, Akifumi, c/o Fujimi Incorporated, Kiyosu-shi Aichi (JP); Kawamura, Atsunori, c/o Fujimi Incorporated, Kiyosu-shi Aichi (JP); Hori, Katsunobu, c/o Fujimi Incorporated, Kiyosu-shi Aichi (JP)
(74) Representative: Paget, Hugh Charles Edward

(57) **Abstract**

A polishing composition comprising the following components (a) to (e):
(a) silicon dioxide,
(b) an alkaline compound,
(c) an anticorrosive,
(d) a water soluble polymer compound, and
(e) water.

## Description

The present invention relates to a polishing composition to be used for production of a wiring structure in a semiconductor device, and a process for producing a wiring structure using it.

In recent years, ULSIs and the like to be used for computers have been developed for high integration and high speed, and along with such progress, a wiring structure in a semiconductor layer has been progressively refined. A wiring structure in a semiconductor device usually comprises an insulating layer having wiring grooves on its surface, a barrier layer which protects the insulating layer and a conductor layer constituting a wiring portion. Along with refinement of such a wiring structure, the resistance of the wiring increases. Accordingly, use of a metal material containing copper which has a low resistance has been studied as a wiring material to be used for formation of a conductor layer.

A wiring structure is produced usually by the following process. First, a barrier layer made of a tantalum-containing compound (such as tantalum or tantalum nitride) is formed on wiring grooves of an insulating layer, and then a conductor layer is formed on the barrier layer. Then, the conductor layer and the barrier layer are polished by CMP (chemical mechanical polishing) process to planalize the surface of the wiring structure. In this polishing process, in a first polishing step, the conductor layer is polished so that the barrier layer at a portion other than a portion corresponding to the wiring grooves is exposed. Then, in a second polishing step, the barrier layer is polished so that the insulating layer at a portion other than a portion corresponding to the wiring grooves is exposed.

As a polishing composition to be used for production of a wiring structure, one comprising an abrasive, an oxidizing agent, a complexing agent and a film forming agent has been known (JP-A-11-21546). Further, a polishing composition comprising an etching agent for an oxidized metal, an agent capable of forming a protection film, and an agent for assisting the dissolution of said agent capable of forming a protection film, has been known (WO 00/39844). By the polishing compositions disclosed in such Patent Documents, the surface of a metal oxidized by the oxidizing agent is complexed (dissolved) by the complexing agent (the etching agent for an oxidized metal), whereby the polishing force against a wiring metal is increased. Further, corrosion on the surface of the conductor layer is suppressed by the film forming agent (the agent capable of forming a protection film).

When the above-disclosed polishing composition is used, the conductor layer may be excessively polished, whereby such a phenomenon (dishing) may occur that the surface of the conductor layer recedes down from the surface of the insulating layer. Further, the barrier layer and the insulating layer at a portion close to the barrier layer may be excessively polished, whereby such a phenomenon (fang) may occur that the barrier layer and the insulating layer recede down from the surface of the conductor layer. Accordingly, when such a conventional polishing composition is used, there may be irregularities on the surface of a wiring structure due to such dishing or fang.

Under these circumstances, the present invention has been made to solve the above problems of the conventional technology. It is an object of the present invention to provide a polishing composition which can suppress irregularities on the surface of a wiring structure and with which a favorable stock removal rate can be obtained.

The present invention provides a polishing composition comprising the following components (a) to (e) :
(a) silicon dioxide,
(b) an alkaline compound,
(c) an anticorrosive,
(d) a water soluble polymer compound, and
(e) water.

Further, the present invention provides a process for producing a wiring structure, which comprises polishing a wiring structure comprising an insulating layer having wiring grooves on its surface, a barrier layer formed on the insulating layer and a conductor layer formed on the barrier layer and completely embedded in the wiring grooves, so that the conductor layer remains only in the wiring grooves, characterized in that the process comprises a first polishing step of polishing the conductor layer until the barrier layer at a portion other than a portion corresponding to the wiring grooves is exposed and a second polishing step of polishing the exposed barrier layer until the insulating layer is exposed, and in the second polishing step, polishing is carried out by means of the above polishing composition.

According to the present invention, in a polishing step in production of a wiring structure, irregularities on the surface can be suppressed, and further, a favorable stock removal rate can be obtained.
In the accompanying drawings:
   Fig. 1 is an enlarged cross-sectional view illustrating a wiring structure.
   Fig. 2 is an enlarged cross-sectional view illustrating a laminate.
   Fig. 3 is an enlarged cross-sectional view illustrating a laminate after completion of a first polishing step.
   Fig. 4 (a) is an enlarged cross-sectional view illustrating a substantial portion of a laminate after completion of a first polishing step, and Fig. 4 (b) is an enlarged cross-sectional view illustrating a substantial portion of a wiring structure.
   Fig. 5 is an enlarged cross-sectional view illustrating a substantial portion of a wiring structure.
   Now, the present invention will be described in detail with reference to the preferred embodiments.

### POLISHING COMPOSITION

### (a) Silicon Dioxide

The polishing composition of the present invention comprises silicon dioxide. This silicon dioxide functions mainly as abrasive grains for mechanical polishing. The silicon dioxide may, for example, be colloidal silica (colloidal SiO₂), fumed silica (fumed SiO₂) or precipitated silica (precipitated SiO₂). Such a silicon dioxide may be used alone or in combination of two or more of them. Among them, preferred is colloidal silica or fumed silica, which is excellent in dispersion stability and with which the stock removal rate immediately after preparation of the polishing composition is likely to be continuously maintained, and more preferred is colloidal silica.

The average particle size of the silicon dioxide is preferably at least 0.01 µm, more preferably at least 0.03 µm, with a view to obtaining a sufficient stock removal rate. On the other hand, it is preferably at most 0.5 µm, more preferably at most 0.3 µm, with a view to efficiently suppress irregularities on the surface. The average particle size means an average particles size (D_{N4}) by means of a laser light diffraction method.

The polishing composition of the present invention is suitably used for production of a wiring structure comprising an insulating layer having wiring grooves on its surface, a conductor layer embedded in the wiring grooves and a barrier layer present between the insulating layer and the conductor layer, as described hereinafter. With a view to obtaining the stock removal rates of the insulating layer and the barrier layer in a well balanced manner for such an application, it is preferred to use a silicon dioxide (first particles, average particle size D1) having a large average particle size and a silicon dioxide (second particles, average particle size D2) having a particle size smaller than that of the first silica) in combination. The average particle size D1 is preferably at least 0.03 µm, more preferably at least 0.05 µm, with a view to improving the stock removal rate of the insulating layer. On the other hand, the average particle size D1 is preferably at most 0.3 µm, more preferably at most 0.1 µm, with a view to efficiently suppressing irregularities on the surface. The average particle size D2 is preferably at most 0.1 µm, more preferably at most 0.05 µm, with a view to obtaining a sufficient stock removal rate of the barrier layer. On the other hand, the average particle size D2 is at least 0.01 µm, more preferably at least 0.02 µm, with a view to obtaining a sufficient stock removal rate of the barrier layer. In a case where it is required to improve the stock removal rate of the insulating layer rather than the stock removal rate of the barrier layer, it is preferred that the content of the second particles is higher than the content of the first particles. On the other hand, in a case where it is required to improve the stock removal rate of the barrier layer rather than the stock removal rate of the insulating layer, it is preferred that the content of the second particles is higher than the content of the first particles.

The content of the silicon dioxide in the polishing composition is preferably at least 0.01 mass%, more preferably at least 0.1 mass%, with a view to obtaining sufficient stock removal rates of the insulating layer and the barrier layer. On the other hand, it is preferably at most 20 mass%, more preferably at most 15 mass%, with a view to efficiently suppressing irregularities on the surface.

### (b) Alkaline Compound

The polishing composition of the present invention comprises an alkaline compound. The alkaline compound has a function to improve the rate of chemical polishing. Such an alkaline compound may be either an organic substance or an inorganic substance depending upon the situation, but is preferably at least one member selected from the group consisting of ammonia, an amine compound and an alkali metal hydroxide, more preferably ammonia or potassium hydroxide.

The content of the alkaline compound in the polishing composition is preferably at least 0.01 mass%, more preferably at least 0.1 mass%, with a view to obtaining a sufficient stock removal rate and in view of stability of the polishing compound. On the other hand, it is preferably at most 10 mass%, more preferably at most 2 mass%, in view of safety in handling of the composition and with a view to suppressing corrosion on the surface.

### (c) Anticorrosive

The polishing composition of the present invention comprises an anticorrosive. The anticorrosive has a function to protect the surface of the conductor layer from corrosion, thereby to suppress irregularities on the surface. As such an anticorrosive, at least one of benzotriazole, benzimidazole, triazole, imidazole, tolyltriazole, and a derivative thereof is used. Among them, benzotriazole or a derivative thereof is preferred, which has a high anticorrosive effect. The benzotriazole derivative may, for example, be
1-(1,2-dicarboxyethyl)benzotriazole,
1-[N,N-bis(hydroxyethyl)aminomethyl]benzotriazole,
1-(2,3-dihydroxypropyl)benzotriazole and
1-(hydroxymethyl)benzotriazole.

The content of the anticorrosive in the polishing composition is preferably at least 0.001 mass%, more preferably at least 0.01 mass%, with a view to sufficiently suppressing irregularities on the surface such as fang or dishing. On the other hand, it is preferably at most 10 mass%, more preferably at most 2 mass%, with a view to maintaining a sufficient stock removal rate.

### (d) Water Soluble Polymer Compound

The polishing composition of the present invention comprises a water soluble polymer compound. The water soluble polymer compound has an effect to suppress irregularities on the surface in combination with the alkaline compound or the anticorrosive at the time of polishing.

As such a water soluble polymer compound, various polymers having hydrophilic groups may be used, and specifically, it may, for example, be a polysaccharide or a vinyl polymer.

The polysaccharide may, for example, be starch, amylopectin, glycogen, water soluble cellulose, pullulan or elsinan. Further, the vinyl polymer may be a vinyl polymer having hydrophilic groups such as hydroxyl groups, carboxyl groups or sulfonic acid groups, for example, a polyvinyl alcohol. The polishing composition of the present invention comprises at least one of them, and among them, water soluble cellulose, pullulan or a polyvinyl alcohol is preferred in view of excellent effect of suppressing irregularities on the surface. Such a water soluble polymer compound may have various molecular weights, and for the polishing composition of the present invention, the polysaccharide has a molecular weight, as the number average molecular weight as calculated as polystyrene, of preferably from 100,000 to 5,000,000, more preferably from 200,000 to 2,000,000, and the vinyl polymer has a molecular weight of preferably from 10,000 to 500,000, more preferably from 50,000 to 200,000.

The content of the water soluble polymer compound in the polishing composition is preferably at least 0.001 mass%, more preferably at least 0.01 mass%, with a view to maintaining a sufficient stock removal rate of the conductor layer and efficiently suppressing irregularities on the surface. On the other hand, it is preferably at most 10 mass%, more preferably at most 1 mass%, with a view to maintaining a sufficient stock removal rate of the barrier layer and suppressing occurrence of dishing.

### (e) Water

The polishing composition of the present invention comprises water as a dispersion medium or a solvent in which the respective components are dispersed or dissolved. Water is preferably water containing impurities as little as possible with a view to suppressing inhibition of the effects of the other components, and specifically, it is preferably pure water or ultrapure water from which impurity ions are removed by an ion exchange resin and then foreign matters are removed through a filter or a distilled water.

### (f) Oxidizing Agent

The polishing composition of the present invention may contain an oxidizing agent as the case requires. The oxidizing agent has an effect to improve the stock removal rate of the conductor layer. Further, the stock removal rate of the conductor layer will be adjusted by adjustment of the concentration of the oxidizing agent, whereby it becomes possible to more efficiently suppress irregularities on the surface. Such an oxidizing agent may, for example, be hydrogen peroxide, a persulfate, a periodate, a perchlorate or a nitrate, or an oxidizing metal salt. It is preferably hydrogen peroxide solution which is easily available and contains metal impurities in a small amount.

The content of the oxidizing agent in the polishing composition is preferably at least 0 mass%, more preferably at least 0.1 mass%, with a view to obtaining an effect of adjusting the stock removal rate of the conductor layer. On the other hand, it is preferably at most 20 mass%, more preferably at most 5 mass%, with a view to reducing excessive polishing of the conductor layer and effectively suppressing irregularities on the surface.

### (g) Other Components

The polishing composition of the present invention may contain another component such as a chelating agent, a thickener, an emulsifier, a rust-prevention agent, a preservative, a fungicide or an antifoaming agent as the case requires in accordance with a conventional method.

The polishing composition of the present invention is prepared by dissolving or dispersing the above respective components in water. The method of dissolution or dispersion is optional, and the order of mixing and the method of mixing the respective components are not particularly limited.

The pH of the polishing composition of the present invention is not particularly limited, and may be adjusted by the amount of an acid or the like added. The pH is preferably from 7.5 to 12, more preferably from 8 to 10, with a view to maintaining favorable handling efficiency of the polishing composition.

The polishing composition of the present invention may be prepared, stored or transported in the form of a stock solution having a relatively high concentration, so that it may be diluted for use at the time of actual polishing operation. The above-mentioned preferred range for the concentration is one for the actual polishing operation. Needless to say, in the case of adopting such a method of use, the stock solution during the storage or transportation is a solution having a higher concentration.

### POLISHING PROCESS

The polishing process by the present invention is to polish a wiring structure comprising an insulating layer having wiring grooves on its surface, a conductor layer embedded in the wiring grooves and a barrier layer present between the insulating layer and the conductor layer, by the above-mentioned polishing composition.

Now, the wiring structure will be explained in detail below prior to explanation of one embodiment of the polishing process by the present invention.

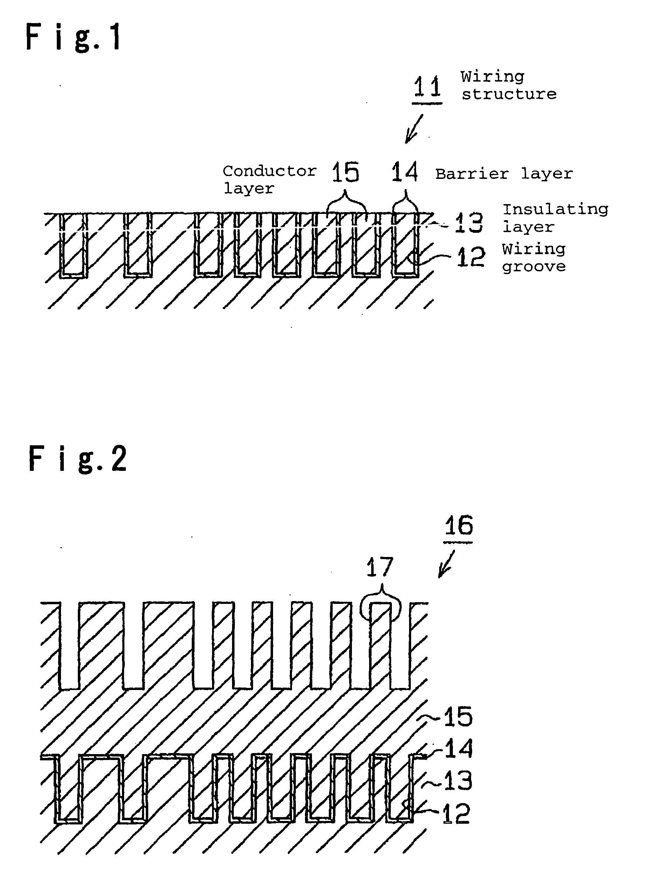

As shown in Fig. 1, a wiring structure 11 in a semiconductor device comprises an insulating layer 13 having wiring grooves 12 on its surface, a barrier layer 14 which protects the insulating layer 13 and a conductor layer 15 constituting a wiring portion. The inner wall of the wiring grooves 12 is covered with the barrier layer 14, and the conductor layer 15 is embedded in the inner side of the barrier layer 14. The barrier layer 14 is present between the insulating layer 13 and the conductor layer 15 to prevent the component of the conductor layer 15 from being diffused into the insulating layer 13. The surface of the wiring structure 11 is smoothly formed by the conductor layer 15, the barrier layer 14 and the insulating layer 13.

As specific examples of an insulating material to be used for the insulating layer 13, in general, SiO₂ or SiOF, or a low dielectric constant insulating material called a Low-k material may be mentioned, and the insulating layer 13 is formed by means of e.g. CVD (chemical vapor deposition) process from SiH₄, SiH₂C₁₂, TEOS (tetraethoxysilane), an organic silicon compound or the like as a starting material. The wiring grooves 12 are formed by known lithography, pattern etching or the like based on the circuit design of a semiconductor device. The barrier layer 14 is formed usually from a tantalum-containing compound such as tantalum or tantalum nitride by means of sputtering or the like. The conductor layer 15 is formed from copper or a copper alloy. The copper alloy may, for example, be usually a copper-aluminum alloy or a copper-titanium alloy.

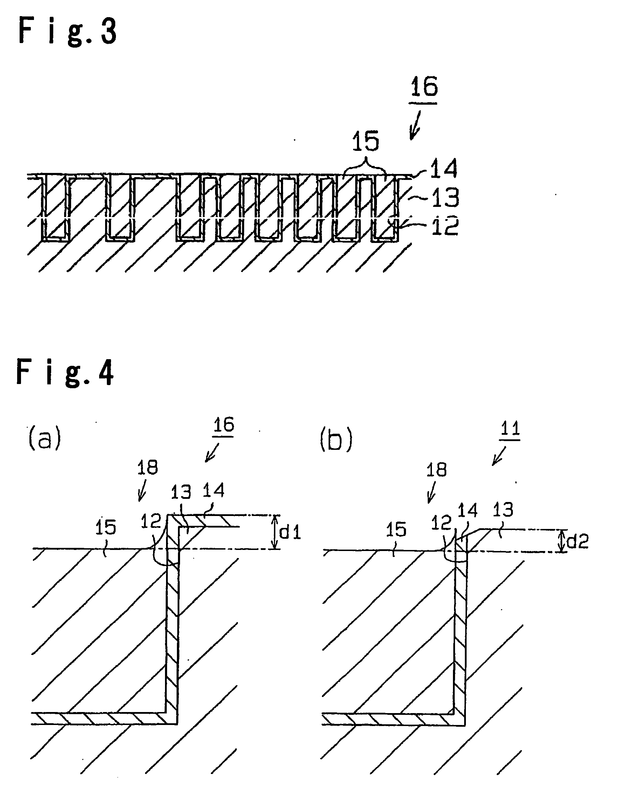

The wiring structure 11 is produced, for example, as follows. First, as shown in Fig. 2, an insulating layer 13, a barrier layer 14 and a conductor layer 15 are laminated to form a laminate 16. On the surface of the conductor layer 15, initial concave grooves 17 derived from wiring grooves 12 are formed. Then, by means of CMP process, the initial concave grooves 17 are removed, and further, the conductor layer 15 and the barrier layer 14 at a portion other than a portion in the wiring grooves 12 are removed, whereby a wiring structure 11 as shown in Fig. 1 is formed. The polishing process in such a case comprises a first polishing step of polishing the conductor layer 15 so that the barrier layer 14 at a portion other than a portion in the wiring grooves 12 is exposed as shown in Fig. 3, and a second polishing step of polishing mainly the exposed barrier layer 14 so that the insulating layer 13 at a portion other than a portion in the wiring grooves 12 is exposed. Namely, the first polishing step is carried out at a relatively high stock removal rate considering the stock removal rate i.e. productivity, since smoothness on the polished surface is not relatively important until the barrier layer 14 is exposed, and then finish polishing is carried out to obtain a final polished surface excellent in smoothness in the second polishing step. Another polishing step may be carried out in combination as the case requires. The polishing composition of the present invention is particularly suitable for the second polishing step.

Now, the polishing process and the process for producing a wiring structure using the polishing composition of the present invention will be explained in further detail below.

First, in the first polishing step, the laminate 16 is polished by using a slurry for polishing the conductor layer. In the laminate 16 after the first polishing step, the conductor layer 15 on the wiring grooves 12 may be excessively polished and recedes down from the surface of the barrier layer 14, thus causing dishing 18 as shown in Fig. 4 (a) in some cases.

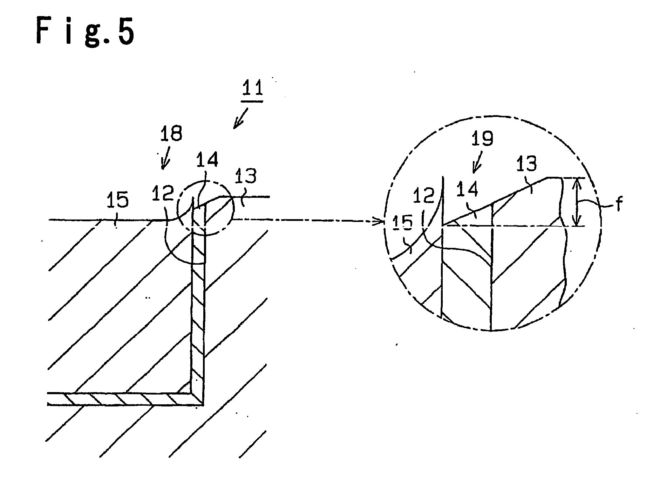

Then, in the second polishing step, the laminate 16 after the first polishing step is polished by a polishing composition, whereby the barrier layer 14 is removed and further, the insulating layer 13 at a portion other than a portion in the wiring grooves is exposed. If a conventional polishing composition is used as the polishing composition, the barrier layer 14 and the insulating layer 13 at a portion close to the barrier layer 14 may be excessively polished, whereby the barrier layer 14 and the insulating layer 13 recede down from the surface of the conductor layer 15, thus causing fang 19 as shown in Fig. 5 in some cases.

The polishing composition of the present invention has an effect of suppressing irregularities on the surface due to the alkaline compound, the anticorrosive and the water soluble polymer compound. The mechanism is not clearly understood, but is estimated to be such that these components are selectively adsorbed or dissolved in the barrier layer 14 or the conductor layer 15, whereby they contribute to appropriate polishing of the barrier layer 14 and the conductor layer 15 and a portion close thereto, and thus fluidity of the polishing composition on a portion at which the dishing 18 occurs and on the surface of the exposed insulating layer 13 improves, and local retention or residence of the polishing composition is suppressed, whereby occurrence of the dishing 18 or the fang 19 is also suppressed.

Now, the present invention will be explained in detail with reference to specific Examples. However, it should be understood that the present invention is by no means restricted to such specific Examples.

### EXAMPLES 1 TO 18 AND COMPARATIVE EXAMPLES 1 TO 8

A silicon dioxide, an alkaline compound, an anticorrosive, a water soluble polymer compound and an oxidizing agent were blended with water to prepare a polishing composition. Components and addition amounts for each polishing composition are as shown in Table 1. Further, abbreviations in items for the respective components in Table 1 have the following meanings. Silicon Dioxide
C1: average particle size 0.07 µm
C2: average particle size 0.03 µm
C3: average particle size 0.21 µm
Alkaline Compound
NH3: ammonia
KOH: potassium hydroxide
Mal: malic acid
Anticorrosive
BTA: benzotriazole
E1: 1-[N,N-bis(hydroxyethyl)aminoethyl]benzotriazole
E2: tolyltriazole
F1: carboxyethylbenzotriazole
Water Soluble Polymer Compound
A1: pullulan (molecular weight about 200,000)
A2: polyvinyl alcohol (completely saponified type, molecular weight about 200,000)
A3: hydroxyethylcelulose (molecular weight about 1,600,000)
B1: D(+)glucose
B2: triethanolamine dodecylbenzenesulfonate
Oxidizing Agent
H2O2: Hydrogen peroxide
APS: Ammonium persulfate

Using each of the polishing compositions, polishing and evaluation were carried out under the following conditions.

### EVALUATION OF STOCK REMOVAL RATE

First, blanket wafers (diameter 200 mm) made of copper, tantalum, TEOS and BD (black diamond, manufactured by APPLIED MATERIALS) were polished under the following polishing conditions 1, and the stock removal rate was evaluated.

### Polishing Conditions 1

Polishing machine: one side polishing machine for CMP (Mirra, manufactured by APPLIED MATERIALS)
Polishing pad: laminated polishing pad made of polyurethane (IC-1400, manufactured by Rodel Inc.)
Polishing pressure: 2 psi (=about 28 kPa)
Table rotational speed: 80 rpm
Feed rate of polishing composition: 200 mL/min
Carrier rotational speed: 80 rpm
Calculating Formula for Stock Removal Rate
Stock removal rate (nm/min)={(thickness (nm) of blanket wafer before polishing)-(thickness (nm) of blanket wafer after polishing)}÷(polishing time (min))
   The thicknesses of the blanket wafers of Cu and Ta before and after the polishing were measured by means of a sheet resistance measuring device (VR-120, manufactured by Kokusai Electronics Semiconductor Service Inc.). Further, the thicknesses of the blanket wafers of TEOS and BD before and after the polishing were measured by means of a thin layer measuring apparatus (ASET-F5x, manufactured by KLA-Tencor Corporation).

### EVALUATION OF IRREGULARITIES

Now, the irregularities were evaluated as follows. Measurement 1 of Irregularities (Pattern A)

The surface of a copper pattern wafer was polished by using a polishing composition (PLANERLITE-7105, manufactured by FUJIMI INCORPORATED) for a first polishing step under the following polishing conditions 2 until the barrier layer was exposed. After the above polishing, the surface of the copper pattern wafer was polished by using each of the polishing compositions of the respective Examples under the above polishing conditions 1 for a polishing time calculated from the following calculating formula. Then, at isolated wiring portions with a width of 100 µm on the surface of the copper pattern wafer after the second polishing, the dishing amount was measured by means of a profiler (HRP340, manufactured by KLA-Tencor Corporation) which is a contact type surface measuring apparatus. The dishing before polishing was 60 nm.

The dishing was evaluated based on four standards ⊚: less than 20 nm, ○: 20 to 40 nm, Δ: 40 to 60 nm and X : 60 nm or more. A case where the barrier layer could not completely be removed by polishing was separately rated (-).

### Measurement 1 of Irregularities (Pattern B)

The surface of a copper pattern wafer was polished by using a polishing composition (DCM-CX1C, manufactured by FUJIMI INCORPORATED) for a first polishing step under the following polishing conditions 3 until the barrier layer was exposed. After the above polishing, the surface of the copper pattern wafer was polished by using each of the polishing compositions of the respective Examples under the above polishing conditions 1 for a polishing time calculated from the following calculating formula. Then, at isolated wiring portions with a width of 100 µm on the surface of the copper pattern wafer after the second polishing, the dishing amount was measured by means of a profiler (HRP340, manufactured by KLA-Tencor Corporation) which is a contact type surface measuring apparatus. The dishing before polishing was 10 nm.

The dishing was evaluated based on five standards ▲: less than -5 nm, △: -5 to 0 nm, ⊚: 0 to 15 nm, ○: 15 to 30 nm and X: 30 nm or more. A case where the barrier layer could not completely be removed by polishing was separately rated (-).

### Calculating Formula for Polishing Time

Polishing time (min)={(thickness 250 (nm) of Ta layer of pattern wafer)÷(stock of removal rate (nm/min) of Ta blanket wafer)}+{(polishing amount 400 (nm) of TEOS of pattern wafer)÷(stock removal rate (nm/min) of TEOS blanket wafer)}

### Polishing Conditions 2

Polishing machine: one side polishing machine for CMP (Mirra, manufactured by APPLIED MATERIALS)
Object to be polished: copper pattern wafer (manufactured by SEMATECH Inc., 854 mask patterns, layer thickness 10,000 Å, initial concave grooves 8,000 Å)
Polishing pad: laminated polishing pad made of polyurethane (IC-1000/Suba IV, manufactured by Rodel Inc.)
Polishing pressure: 2 psi (=about 28 kPa)
Table rotational speed: 100 rpm
Feed rate of polishing composition: 200 mL/min
Carrier rotational speed: 100 rpm
Polishing Conditions 3
Polishing machine: one side polishing machine for CMP (Mirra, manufactured by Applied Materials)
Object to be polished: copper pattern wafer (manufactured by SEMATECH Inc., 854 mask patterns, layer thickness 10,000 Å, initial concave grooves 8,000 Å)
Polishing pad: laminated polishing pad made of polyurethane (IC-1400, manufactured by Rodel Inc.)
Polishing pressure: 2 psi (=about 28 kPa)
Table rotational speed: 60 rpm
Feed rate of polishing composition: 200 mL/min
Carrier rotational speed: 60 rpm

### EVALUATION OF STABILITY

The stock removal rate immediately after preparation of the polishing composition was obtained. Then, the polishing composition was stored in a closed container at room temperature, the stock removal rate was obtained in the same manner as mentioned above every constant elapsed time after initiation of the storage, and the elapsed time when the stock removal rate decreased by 20% from the stock removal rate immediately after the preparation was taken as the life. The life was evaluated based on four standards ⊚: one year or more, ○: half year or more and less than one year, Δ: one month or more and less than half year and X: less than one month.

The results obtained in the respective evaluations were as shown in Table 1.

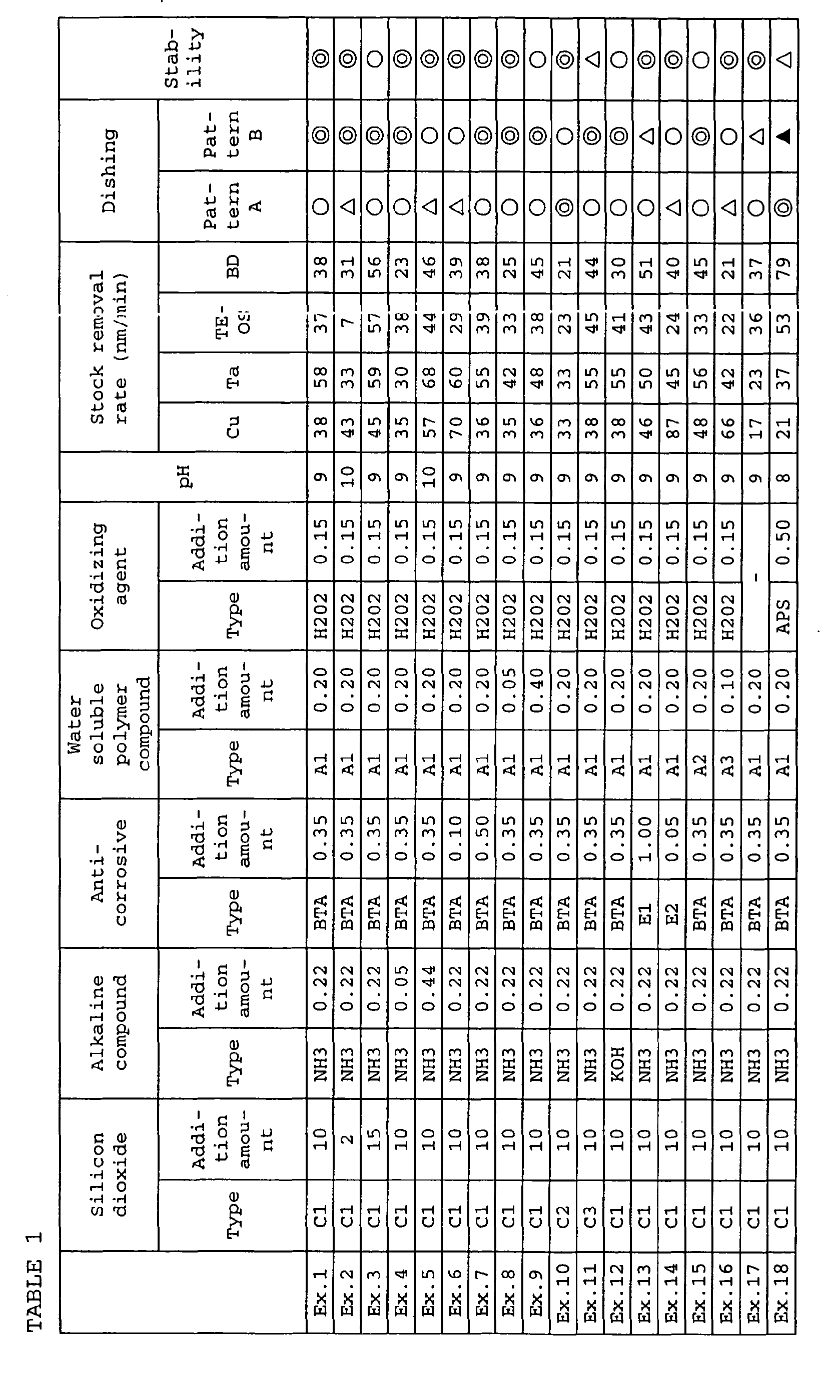

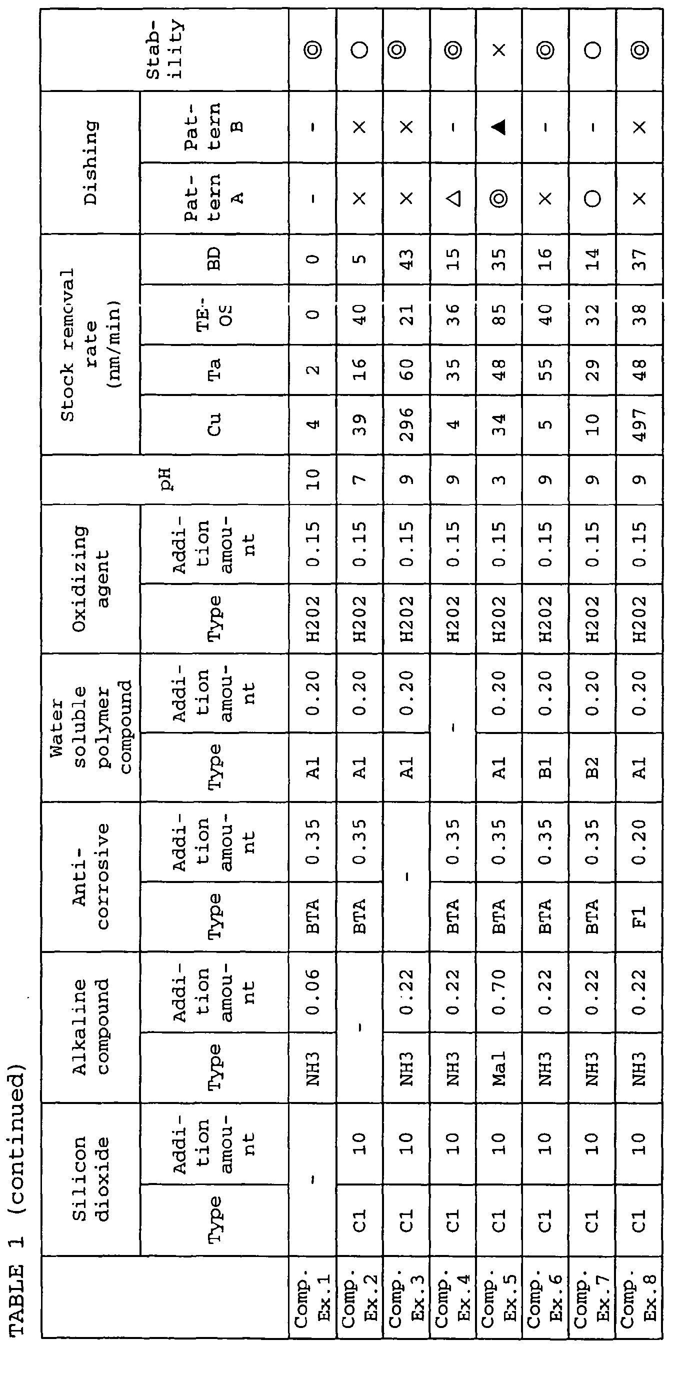

From these results, the following become clear.
(1) From the results in Examples 1 to 18, the polishing composition of the present invention can sufficiently suppress dishing on a pattern wafer, and has a sufficient stability.
(2) When the average particle size of the silicon dioxide becomes large, the stock removal rates of TEOS and BD wafers tend to be high. Further, when the average particle size becomes small, the effect of suppressing dishing tends to be high, and the stability tends to be high as well.
(3) The polishing composition of the present invention, which contains an oxidizing agent, has improved stock removal rates of copper and tantalum. When ammonium persulfate is used as the oxidizing agent, a higher effect of suppressing dishing tends to be obtained, and when hydrogen peroxide is used as the oxidizing agent, reverse dishing (a phenomenon that the wiring portion remains on the contrary) is less likely to occur, and a favorable stability tends to be obtained.
(4) The polishing composition of the present invention is excellent in stability as compared with a polishing composition (Comparative Example 5) containing an acid. Further, it has a remarkably high stock removal rate as compared with a polishing composition (Comparative Example 1) containing no silicon dioxide. Further, the polishing composition of the present invention has a high effect of suppressing dishing as compared with polishing compositions (Comparative Examples 2 to 4 and 6 to 8) which do not contain one of the alkaline compound, the anticorrosive and the water soluble polymer compound which are essential for the polishing composition of the present invention.

The entire disclosure of Japanese Patent Application No. 2004-272059 filed on September 17, 2004 including specification, claims, drawings and summary is incorporated herein by reference in its entirety.

## Claims

1. A polishing composition comprising the following components (a) to (e):
(a) silicon dioxide,
(b) an alkaline compound,
(c) an anticorrosive,
(d) a water soluble polymer compound, and
(e) water.

2. The polishing composition according to Claim 1, wherein the alkaline compound is at least one member selected from the group consisting of ammonia, an amine compound and an alkali metal hydroxide.

3. The polishing composition according to Claim 1 or 2, wherein the anticorrosive is selected from the group consisting of benzotriazole and a derivative thereof.

4. The polishing composition according to any one of Claims 1 to 3, wherein the water soluble polymer compound is at least one member selected from the group consisting of a polysaccharide and a vinyl polymer.

5. The polishing composition according to any one of Claims 1 to 4, which further contains an oxidizing agent (f) .

6. A process for producing a wiring structure, which comprises polishing a wiring structure comprising an insulating layer having wiring grooves on its surface, a barrier layer formed on the insulating layer and a conductor layer formed on the barrier layer and completely embedded in the wiring grooves, to produce a wiring structure in which the conductor layer remains only in the wiring grooves, **characterized in that** the process comprises a first polishing step of polishing the conductor layer until the barrier layer at a portion other than a portion corresponding to the wiring grooves is exposed and a second polishing step of polishing the exposed barrier layer until the insulating layer is exposed, and in the second polishing step, polishing is carried out by means of the polishing composition as defined in any one of Claims 1 to 5.

7. The process for producing a wiring structure according to Claim 6, wherein the barrier layer is made of a tantalum-containing compound.

8. The process for producing a wiring structure according to Claim 6 or 7, wherein the conductor layer is made of copper or a copper alloy.
